# EUROPEAN PATENT APPLICATION

(11) **EP 4 750 046 A1**
(43) Date of publication of application: **27.05.2026**
(21) Application number: 24882602.6
(22) Date of filing: 07.08.2024
(51) Int. Cl.: H04N 5/655, H05K 5/03, H01L 25/075, G09F 9/302

(54) **DISPLAY APPARATUS**

(30) Priority: 23.10.2023 KR 20230142491
(71) Applicant: Samsung Electronics Co., Ltd., Suwon-si, Gyeonggi-do 16677 (KR)
(72) Inventor: KIM, Jisu, Suwon-si Gyeonggi-do 16677 (KR); KIM, Seungjae, Suwon-si Gyeonggi-do 16677 (KR); OH, Pilyong, Suwon-si Gyeonggi-do 16677 (KR); LEE, Kwangjae, Suwon-si Gyeonggi-do 16677 (KR)
(74) Representative: Appleyard Lees IP LLP
(86) International application number: PCT/KR2024/011644
(87) International publication number: WO 2025/089573

(57) **Abstract**

One aspect of the present disclosure provides a display apparatus capable of adjusting a step between a screen and a bezel by adjusting the amount of protrusion of the bezel.

The display apparatus includes: a display panel; a rear cover provided to cover the rear side of the display panel; a front chassis provided to cover the lateral side of the display panel and including a flange facing the rear cover to be coupled to the rear cover and a first portion forming a bezel of the display panel; a bracket provided to support the flange between the front chassis and the rear cover; and a step adjusting device configured to adjust a step between the front chassis and the display panel. The step adjusting device includes a connecting member provided to connect the front chassis to the bracket, and an adjusting member provided to pass through the front chassis and be coupled to the connecting member, wherein the adjusting member is interlocked with the front chassis according to a fastening amount with respect to the connecting member to move the bezel forward or backward.

## Description

### [Technical Field]

The present disclosure relates to a display apparatus.

### [Background Art]

A display apparatus is an output device that visually displays data information such as characters, shapes, and images.

Generally, liquid crystal panels, which require a backlight or Organic Light-Emitting Diode (OLED) panels, which are formed of a film of organic compounds that emit light by themselves in response to electric current, are mainly used as a display apparatus.

However, the liquid crystal panels have slow response times, high power consumption, and difficulty in compactness because the liquid crystal panels do not emit light by themselves and require a backlight. In addition, the OLED panels do not require a backlight because the OLED panels emit light by themselves, and may be made thin. However, the OLED panels are vulnerable to burn-in risk which is if the same screen is displayed for a long time, a lifespan of a sub-pixel expires, and a certain part of the previous screen remains even when the screen is changed.

Accordingly, as a new panel to replace the OLED panels, micro light-emitting diode (micro-LED or µLED) display panels that mount inorganic light-emitting elements on a substrate and use the inorganic light-emitting elements themselves as pixels, are being studied.

A micro light-emitting diode display panel (hereinafter micro-LED panel) is one of flat panel display panels and is composed of a plurality of inorganic light-emitting diodes (inorganic LEDs), each of which is 100 micrometers or less in size.

The LED panels are also self-luminous elements but are inorganic light-emitting elements. Therefore, the LED panels do not suffer from the burn-in risk of OLEDs and have excellent brightness, resolution, power consumption, and durability.

In comparison with the LCD panels that require a backlight, the micro-LED display panels offer better contrast, response time, and energy efficiency. Both organic light-emitting diodes (OLEDs) and micro-LEDs corresponding to inorganic light-emitting diodes are energy efficient, but the micro-LEDs offer greater brightness, luminous efficacy, and a longer lifespan than the OLEDs.

In addition, by arranging LEDs on a circuit board in pixel units, display modularization may be produced on a board-by-board basis, and it is easy to produce various resolutions and screen sizes to meet consumer orders.

In the display industry, thin bezels and thin displays are typically key differentiators. To meet these requirements, the trend is toward manufacturing bezels formed of metal. Micro-LED display panels are shaped by applying a metal material to implement a thin bezel.

### [Disclosure]

### [Technical Problem]

The present disclosure is directed to providing a display apparatus capable of adjusting a step between a screen and a bezel.

Further, the present disclosure is directed to providing a display apparatus including a structure capable of adjusting a protrusion amount of a bezel.

Further, the present disclosure is directed to providing a display apparatus capable of adjusting a step between a screen and a bezel by adjusting a protrusion amount of the bezel.

Further, the present disclosure is directed to providing a display apparatus capable of preventing a front chassis from being retracted relative to a display module due to bending.

Further, the present disclosure is directed to providing a display apparatus capable of securing a constant protrusion amount on a screen edge by adjusting a protrusion amount of a bezel.

Additional aspects of the disclosure will be set forth in part in the description which follows and, in part, will be obvious from the description, or may be learned by practice of the disclosure.

### [Technical Solution]

One aspect of the present disclosure provides a display apparatus including: a display panel; a rear cover provided to cover a rear side of the display panel; a front chassis provided to cover a side portion of the display panel and including a flange facing the rear cover to be coupled to the rear cover and a first portion forming a bezel of the display panel; a bracket provided to support the flange between the front chassis and the rear cover; and a step adjusting device configured to adjust a step between the bezel and the display panel. The step adjusting device includes: a connecting member provided to connect the front chassis to the bracket; and an adjusting member provided to penetrate the front chassis and be coupled to the connecting member, the adjusting member provided to allow the bezel to be moved forward or backward by being interlocked with the front chassis according to an amount of fastening with the connecting member.

Another aspect of the present disclosure provides a display apparatus including: a display panel including a self-luminous element; a frame coupled to the display panel at a rear side of the display panel to support the display panel; a rear cover provided to cover the rear side of the display panel; a front chassis including a first portion forming a bezel of the display panel to cover a side portion of the display panel; and a flange formed to extend from the first portion to face the rear cover; a bracket provided to support the flange between the front chassis and the rear cover; a connecting member provided with a male screw formed on one side and a female screw formed on the other side, so as to connect the front chassis and the bracket; and an adjusting member provided to penetrate the front chassis and be fastened to the connecting member, the adjusting member provided to allow the front chassis to be interlocked therewith and moved according to rotation of the adjusting member, provided to allow the first portion to be moved forward in response to the rotation of the adjusting member in a first direction, and provided to allow the first portion to be moved backward in response to the rotation of the adjusting member in a second direction opposite to the first direction.

### [Advantageous Effects]

It is possible to adjust a step between a screen and a bezel through a structure configured to adjust a protrusion amount of the bezel.

Further, it is possible to prevent a front chassis from being retracted relative to a display module due to bending.

Further, it is possible to secure a constant protrusion amount on a screen edge by adjusting a protrusion amount of a bezel.

Further, it is possible to protect a side portion of a screen by allowing an edge bezel portion of the screen to be higher than a display module, and it is possible to have a constant protrusion amount to improve the appearance quality.

Further, a material, in which a protrusion amount of a screen is defective, may be modified and used without being discarded.

Additional aspects of the disclosure will be set forth in part in the description which follows and, in part, will be obvious from the description, or may be learned by practice of the disclosure.

### [Description of Drawings]

FIG. 1 is a view illustrating a display apparatus according to one embodiment.
FIG. 2 is an exploded perspective view illustrating a main configuration of the display apparatus of FIG. 1.
FIG. 3 is an enlarged cross-sectional view of a partial configuration of a display module of the display apparatus of FIG. 1.
FIG. 4 is a rear view illustrating a partial configuration of the display apparatus of FIG. 1.
FIG. 5 is a rear exploded perspective view of the display apparatus of FIG. 5.
FIG. 6 is an enlarged view of a portion A of FIG. 5.
FIG. 7 is an exploded perspective view of the portion A of FIG. 5.
FIG. 8 is a cross-sectional view of a D-D' portion of FIG. 6.
FIGS. 9 and 10 are views illustrating a method of fastening a connecting member according to one embodiment.
FIGS. 11 and 12 are views illustrating fastening of an adjusting member fastened to the connecting member according to one embodiment.
FIGS. 13 and 14 are views illustrating an operating state of the adjusting member according to one embodiment.
FIG. 15 is an enlarged view of a portion B of FIG. 5.
FIG. 16 is an exploded perspective view of the portion B shown in FIG. 15.
FIG. 17 is a cross-sectional view of a E-E' portion of FIG. 15.
FIG. 18 is an enlarged view of a portion C of FIG. 5.
FIG. 19 is an exploded perspective view of the portion C shown in FIG. 18.
FIG. 20 is a cross-sectional view of a F-F' portion of FIG. 18.

### [Modes of the Invention]

The various embodiments and the terms used therein are not intended to limit the technology disclosed herein to specific forms, and the disclosure should be understood to include various modifications, equivalents, and/or alternatives to the corresponding embodiments.

In describing the drawings, similar reference numerals may be used to designate similar constituent elements.

A singular expression may include a plural expression unless otherwise indicated herein or clearly contradicted by context.

The expressions "A or B," "at least one of A or/and B," or "one or more of A or/and B," A, B or C," "at least one of A, B or/and C," or "one or more of A, B or/and C," and the like used herein may include any and all combinations of one or more of the associated listed items.

The term of "and / or" includes a plurality of combinations of relevant items or any one item among a plurality of relevant items.

Herein, the expressions "a first", "a second", "the first", "the second", etc., may simply be used to distinguish an element from other elements, but is not limited to another aspect (importance or order) of elements.

When an element (e.g., a first element) is referred to as being "(functionally or communicatively) coupled," or "connected" to another element (e.g., a second element), the first element may be connected to the second element, directly (e.g., wired), wirelessly, or through a third element.

In this disclosure, the terms "including", "having", and the like are used to specify features, numbers, steps, operations, elements, components, or combinations thereof, but do not preclude the presence or addition of one or more of the features, elements, steps, operations, elements, components, or combinations thereof.

When an element is said to be "connected", "coupled", "supported" or "contacted" with another element, this includes not only when elements are directly connected, coupled, supported or contacted, but also when elements are indirectly connected, coupled, supported or contacted through a third element.

Throughout the description, when an element is "on" another element, this includes not only when the element is in contact with the other element, but also when there is another element between the two elements.

In the following detailed description, the terms of "front", "rear", "left", "right", "upper", "lower" and the like may be defined by the drawings, but the shape and the location of the element is not limited by the term.

A display module may include a display panel. The display panel may be a flat display panel, and may include an array of inorganic light-emitting diodes (inorganic LEDs), each of which is 100 micrometers or less in size. In comparison with liquid crystal display (LCD) panels that require a backlight, micro-LED display modules offer better contrast, response time, and energy efficiency. While both organic light-emitting diodes (OLEDs) and micro-LEDs corresponding to inorganic light-emitting diodes are energy efficient, the micro-LEDs offer greater brightness and luminous efficacy, and a longer lifespan than OLEDs. The micro-LEDs may be semiconductor chips that may emit light on their own when powered. The micro-LEDs have fast response times, low power consumption, and high brightness. Particularly, the micro-LEDs are more efficient at converting electricity into photons than conventional liquid crystal displays (LCDs) or organic light-emitting diodes (OLEDs). This means that the micro-LEDs offer higher brightness per watt than conventional LCD or OLED displays. Accordingly, the micro-LEDs may produce the same brightness with about half the energy compared to conventional LEDs (with width, length, and height exceeding 100 µm) or OLEDs. In addition, the micro-LEDs may implement high resolution, excellent color, contrast, and brightness, so the micro-LEDs may accurately express a wide range of colors and implement clear screens even when the sunlight is bright. In addition, the micro-LEDs are resistant to a burn-in risk and generate little heat, ensuring a long lifespan without deformation.

The micro-LED may include a flip chip type in which anode and cathode electrode terminals are formed on the same first surface and a light-emitting surface is formed on a second surface located opposite the first surface on which the electrode terminals are formed.

A glass substrate may include a thin film transistor (TFT) layer formed with a TFT circuit on the front surface, and a driving circuit for driving the TFT circuit may be disposed on the rear surface. The TFT circuit may drive a plurality of pixels disposed on the TFT layer.

A front surface of the glass substrate may be divided into an active region and an inactive region. The active region may correspond to a region occupied by the TFT layer on the front surface of the glass substrate, and the inactive region may be a region excluding a region occupied by the TFT layer on the front surface of the glass substrate.

An edge region of the glass substrate may be an outermost portion of the glass substrate. In addition, the edge region of the glass substrate may be the remaining region excluding a region of the glass substrate in which the circuit is formed. In addition, the edge region of the glass substrate may include a side surface of the glass substrate, a portion of the front surface of the glass substrate adjacent to the side surface, and a portion of the rear surface of the glass substrate. The glass substrate may be formed in a quadrangle type. Particularly, the glass substrate may be formed in a rectangle or a square. The edge region of the glass substrate may include at least one side among the four sides of the glass substrate.

The display module includes a glass substrate on which a plurality of LEDs is mounted and a side wiring is formed. The display module may be installed and applied as a single unit in wearable devices, portable devices, handheld devices, and various electronic products or electric fields requiring displays, and may be applied to display apparatuses such as monitors for personal computers (PCs), high-resolution TVs, and signage (or digital signage), electronic displays, and the like through multiple assembly arrangements in a matrix type.

Hereinafter display apparatuses according to various embodiments are particularly described with reference to the attached drawings.

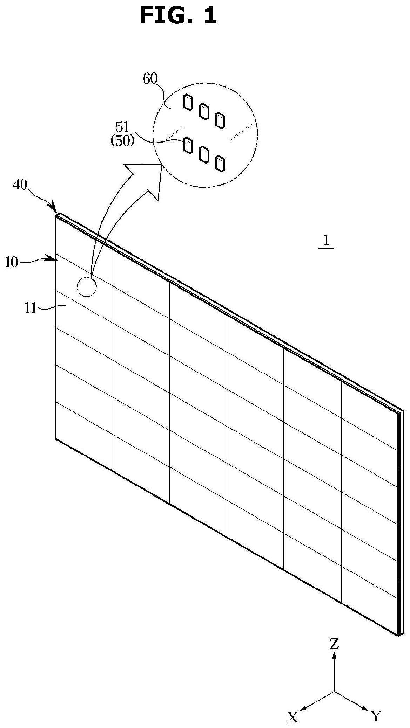

Particularly, as shown in FIG. 1, a direction, in which a display panel 11 faces, is set to the front, and based on this, the rear, left and right sides, and the upper and lower sides are defined.

Hereinafter exemplary embodiments of the present disclosure will be described in detail with reference to the accompanying drawings.

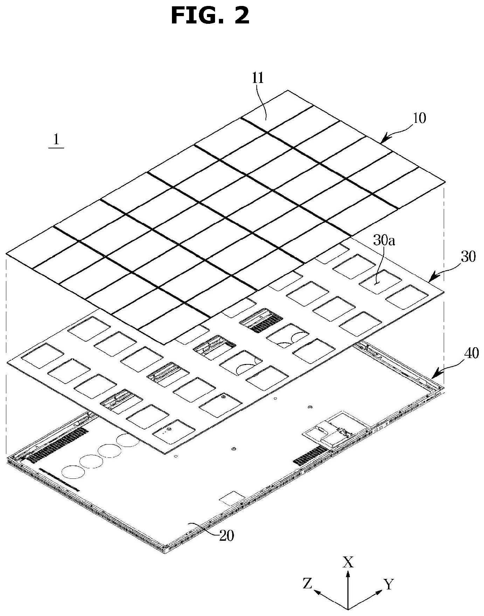

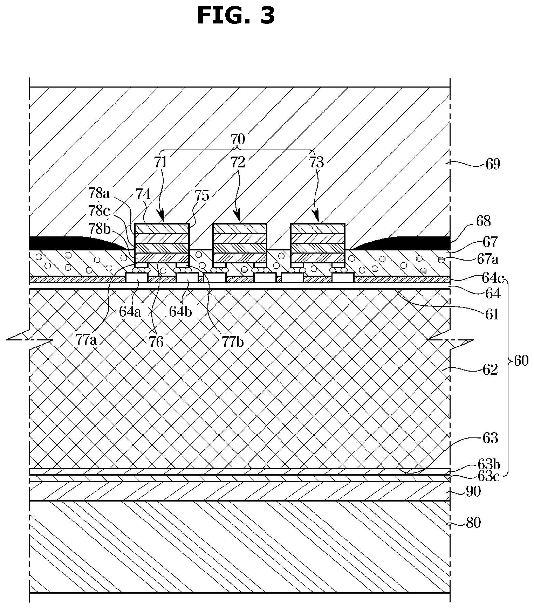

FIG. 1 is a view illustrating a display apparatus according to one embodiment, FIG. 2 is an exploded perspective view illustrating a main configuration of the display apparatus of FIG. 1, and FIG. 3 is an enlarged cross-sectional view of a partial configuration of a display module of the display apparatus of FIG. 1.

A display apparatus 1 is a device that displays information, data, and other information in the form of characters, shapes, graphs, images, and the like and a TV, PC, mobile, digital signage, and the like may be implemented as the display apparatus 1.

As shown in FIGS. 1 to 3, the display panel 11 provided to display an image may be positioned in a front portion of the display apparatus 1.

The display apparatus 1 may include a front chassis 40 extending along an edge of the display panel 11. The front chassis 40 is provided to protect a side portion of the display panel 11.

The display panel 11 and the front chassis 40 may form a front exterior of the display apparatus 1. A rear cover 20 may be provided at a rear side of the front chassis 40 to cover a rear side of the display panel 11. The front chassis 40 may be provided so as to be coupled to the rear cover 20.

The display apparatus 1 may include a power supply (not shown) configured to supply power to the display panel 11 and a main board (not shown) configured to control an overall operation of the display panel 11.

The display apparatus 1 may include a driving board (not shown) configured to drive the display panel 11 or a display module 10 and a Timing Control Board (T-CON board) configured to generate a timing signal required for controlling the display panel 11 or the display module 10.

The display panel 11 may be provided by mounting a plurality of display modules 10. In FIG. 1, 36 display modules 10 are provided and arranged in a 6*6 matrix form, but this is only an example, and there is no limitation on the number and arrangement of the display modules 10. The display module 10 may be formed in a quadrangular shape. That is, the display module 10 may be provided in a rectangular or square shape. The display module 10 may include edges formed in the up, down, left, and right directions based on the front.

The display panel 11 or the display module 10 may include a self-luminous display element or a non-self-luminous display element. The self-luminous display element may visually output an image by emitting light on its own without a separate light source. For example, a light emitting diode (LED), an organic light emitting diode (OLED), a quantum dot-organic light emitting diode (QD-OLED), an inorganic light emitting element (or micro-LED) 70 that is formed of an inorganic light-emitting material and the like may be an element that may emit light on its own based on a supplied current.

The non-self-luminous display element may include a non-self-luminous display element that requires a separate light source. For example, the non-self-luminous element, such as a Liquid Crystal Display (LCD), changes the arrangement of liquid crystals through an electric current, but requires a separate light source to visually output an image through the changed arrangement of liquid crystals.

The display apparatus 1 according to the present disclosure may be applied to both a display panel 11 including a self-luminous display element and a display panel 11 including a non-self-luminous display element. However, for convenience of description, the display apparatus 1 will be described based on an assumption that the display panel 11 includes the self-luminous display element, particularly an inorganic light-emitting element 70.

As illustrated in FIG. 1, the inorganic light-emitting element 70 may be mounted on a substrate 60. Referring to FIG. 3, some components of the display apparatus 1, including the plurality of inorganic light-emitting elements 70 illustrated in the drawing, are micro-unit components having a size of several µm to several hundred µm, and for the convenience of description, the scale of some components (such as the plurality of inorganic light-emitting elements 70, a black matrix 68, and the like) is exaggerated.

The substrate 60 may be formed in a quadrangular shape. As described above, the display module 10 may be provided in a quadrangular shape, and the substrate 60 may be formed in a quadrangular shape to correspond thereto. The substrate 60 may be provided in a rectangular shape or a square shape. The substrate 60 may include four edges corresponding to the edges of the display module 10 formed in the up, down, left, and right directions based on the front.

The substrate 60 may include a base substrate 62, a mounting surface 61 forming one surface of the base substrate 62, a rear surface 63 forming the other surface of the base substrate 62 and positioned opposite the mounting surface 61, and a side surface positioned between the mounting surface 61 and the rear surface 63.

The substrate 60 may include a Thin Film Transistor (TFT) layer 64 formed on the base substrate 62 to drive the inorganic light-emitting element 70. The base substrate 62 may include a glass substrate 60. That is, the substrate 60 may include a Chip On Glass (COG) type substrate 60. The substrate 60 may include a first pad electrode 64a formed thereon to allow the inorganic light-emitting elements 70 to be electrically connected to the TFT layer 64.

The Thin Film Transistor (TFT) forming the TFT layer 64 is not limited to a specific structure or type and may be configured in various embodiments. That is, the TFT of the TFT layer 64 according to one embodiment of the present disclosure may be implemented not only as a Low Temperature Poly Silicon (LTPS) TFT, an oxide TFT, a poly silicon or a-silicon (Si) TFT, but also as an organic TFT, a graphene TFT, and the like.

Further, the TFT layer 64 may be replaced with a Complementary Metal Oxide Semiconductor (CMOS) type or n-type MOSFET or p-type MOSFET transistor when the base substrate 62 of the substrate 60 is formed of a silicon wafer.

The inorganic light-emitting element 70 is formed of an inorganic material and may include an inorganic light-emitting element 70 having a size of several µm to several tens of µm in width, length, and height, respectively. The micro inorganic light-emitting element 70 may have a size in which a cross-sectional length among the width, length, and height is 100 µm or less. That is, the inorganic light-emitting element 70 may be picked up from a wafer formed of a sapphire or silicon material and directly transferred onto the substrate 60. The inorganic light-emitting element 70 may be picked up and transferred by an electrostatic method using an electrostatic head or a stamp method using an elastic polymer material such as PDMS, such as silicon, as a head.

The inorganic light-emitting elements 70 may be light-emitting structures including an n-type semiconductor 78a, an active layer 78c, a p-type semiconductor 78b, a first contact electrode 77a, and a second contact electrode 77b.

Although not shown in the drawing, one of the first contact electrode 77a and the second contact electrode 77b may be electrically connected to the n-type semiconductor 78a and the other may be electrically connected to the p-type semiconductor 78b.

The first contact electrode 77a and the second contact electrode 77b may be in the form of a flip chip type in which the first contact electrode 77a and the second contact electrode 77b are arranged horizontally and face the same direction (opposite to a light-emitting direction).

The inorganic light-emitting element 70 may include a light-emitting surface 74 facing forward when mounted on the mounting surface 61, a side surface, and a bottom surface 76 positioned on the opposite side of the light-emitting surface 74. The first contact electrode 77a and the second contact electrode 77b may be formed on the bottom surface 76.

The contact electrode may be arranged to face the mounting surface 61 and may be electrically connected to the TFT layer 64. The light-emitting surface 74 that emits light in a direction opposite to a direction in which the contact electrode is arranged may be arranged.

Therefore, when light generated from the active layer 78c is emitted forward through the light-emitting surface 74, the light may be emitted forward without interference from the first contact electrode 77a or the second contact electrode 77b.

The first contact electrode 77a and the second contact electrode 77b may be electrically connected to the first pad electrode 64a and a second pad electrode 64b, respectively, formed on the mounting surface 61 of the substrate 60.

The inorganic light-emitting element 70 may be directly connected to the pad electrode through a configuration such as an anisotropic conductive layer 67 or solder.

The anisotropic conductive layer 67 may be formed on the substrate 60 to mediate electrical bonding between the contact electrode and the pad electrode.

The anisotropic conductive layer 67 may have a structure in which an anisotropic conductive adhesive is attached on a protective film and conductive balls 67a are dispersed in an adhesive resin. The conductive balls 67a are conductive spheres surrounded by a thin insulating film, and when the insulating film is broken by pressure, the conductors may be electrically connected to each other.

The anisotropic conductive layer 67 may include an anisotropic conductive film (ACF) in the form of a film and an anisotropic conductive paste (ACP) in the form of a paste.

Therefore, in a process in which the inorganic light-emitting element 70 is mounted on the substrate 60, the insulating film of the conductive ball 67a may be broken in response to a pressure being applied to the anisotropic conductive layer 67, and thus the contact electrode of the inorganic light-emitting element 70 and the pad electrode of the substrate 60 may be electrically connected.

The inorganic light-emitting element 70 may include a red light-emitting element 71, a green light-emitting element 72, and a blue light-emitting element 73, and the inorganic light-emitting element 70 may be mounted on the mounting surface 61 of the substrate 60 as a single unit by forming a series of the red light-emitting element 71, the green light-emitting element 72, and the blue light-emitting element 73. The series of the red light-emitting element 71, the green light-emitting element 72, and the blue light-emitting element 73 may form one pixel. At this time, the red light-emitting element 71, the green light-emitting element 72, and the blue light-emitting element 73 may each form a sub-pixel.

The red light-emitting element 71, the green light-emitting element 72, and the blue light-emitting element 73 may be arranged in a row at a predetermined interval as in the embodiment of the present disclosure, or may be arranged in a different shape, such as a triangular shape.

The substrate 60 may include a light absorbing layer 64c to absorb external light and improve contrast. The light absorbing layer 64c may be formed on the entire mounting surface 61 of the substrate 60. The light absorbing layer 64c may be formed between the TFT layer 64 and the anisotropic conductive layer 67.

The display module 10 may further include the black matrix 68 formed between the inorganic light-emitting elements 70. The black matrix 68 may perform a function of complementing the light absorbing layer 64c formed entirely on the mounting surface 61 of the substrate 60. That is, the black matrix 68 may absorb external light to make the substrate 60 appear black, thereby improving the contrast of the screen.

According to the embodiment, the black matrix 68 is formed to be disposed between pixels formed by a series of the red light-emitting element 71, the green light-emitting element 72, and the blue light-emitting element 73. However, unlike the embodiment, it may be formed more finely to separate each of the inorganic light-emitting elements 70, which are sub-pixels.

The black matrix 68 may be formed in a grid shape having horizontal and vertical patterns to be arranged between pixels. The black matrix 68 may be formed by applying a light-absorbing ink onto the anisotropic conductive layer 67 through an ink-jet process and then curing the light-absorbing ink, or by coating the anisotropic conductive layer 67 with a light-absorbing film.

The display module 10 may include a front cover 69 positioned in front of the mounting surface 61 to cover the mounting surface 61.

The display module 10 may include a heat dissipation member 80 provided on a rear surface of the substrate 60 to dissipate heat generated from the substrate 60.

Heat generated by the substrate 60 may include heat generated from various configurations. Heat that accounts for the largest proportion of the heat generated from the substrate 60 and transferred to the rear surface is heat generated when a plurality of inorganic light-emitting elements 70 emits light. However, heat may be generated from a plurality of configurations arranged on the mounting surface 61 of the substrate 60, such as the TFT layer 64, and the heat generated from the plurality of configurations may be introduced into the substrate 60.

Additionally, heat may be transferred from the outside of the substrate 60 to the substrate 60, and heat may be transferred to the substrate 60 through a configuration outside the substrate 60. Accordingly, heat may be generated in the substrate 60.

Heat generated by the substrate 60 to be described later refers to heat that is generated from the plurality of components disposed on the substrate 60 including substantially inorganic light-emitting elements 70 and introduced into the substrate 60.

Particularly, as described above, the heat generated from the plurality of inorganic light-emitting elements 70 is most introduced into the substrate 60, and the largest proportion of the heat generated in the substrate 60 is the heat generated from the inorganic light-emitting elements 70. However, as described above, it can be said that heat is generated in the substrate 60 by heat generated from various components and the outside of the substrate 60 in addition to the inorganic light-emitting elements 70. In addition, the display module 10 may include an adhesive tape 90 disposed between the rear surface and the heat dissipation member 80 to adhere the rear surface of the substrate 60 and the heat dissipation member 80, respectively.

The inorganic light-emitting element 70 may be electrically connected to a pixel driving wiring (not shown) formed on the mounting surface 61, and an upper wiring layer (not shown) extending through a side surface of the substrate 60 and formed as the pixel driving wiring (not shown).

The upper wiring layer (not shown) may be electrically connected to a side wiring (not shown) formed on the side surface of the substrate 60. The side wiring (not shown) may be provided in a thin film form. The upper wiring layer (not shown) may be connected to the side wiring (not shown) by an upper connection pad (not shown) formed on an edge side of the substrate 60. The side wiring (not shown) may extend along the side surface of the substrate 60 and be connected to a rear wiring layer 63b formed on the rear surface. An insulating layer 63c covering the rear wiring layer 63b may be formed on the rear wiring layer 63b in the direction in which the rear surface of the substrate 60 faces. That is, the plurality of inorganic light-emitting elements 70 may be sequentially electrically connected to the upper wiring layer (not shown), the side wiring (not shown), and the rear wiring layer 63b.

The heat dissipation member 80 may be provided to be in contact with the substrate 60. The heat dissipation member 80 may be formed of a material having high thermal conductivity or may be implemented with a structure having high thermal conductivity. Accordingly, heat generated in the substrate 60 may be transferred to the heat dissipation member 80, and the substrate 60 may be prevented from being higher than or equal to a predetermined temperature.

The display modules 10 may be arranged in various positions in a matrix form of M * N, respectively. Each display module 10 is provided to be individually movable. A plurality of display modules 10 may form screens of various sizes of the display apparatus 1 in a matrix form of various M * N. As described above, the display panel 11 may be arranged on a frame 30 to allow the display modules 10 to form a constant gap. This is because when the gap formed by the plurality of display modules 10 is not constant, the perception of the deafness due to some of the gaps may be amplified.

The frame 30 may be provided to allow a gap length formed between each display module 10 to be maintained to be constant. The frame 30 may be provided to have a stiffness greater than a predetermined size and configured to support the display panel 11.

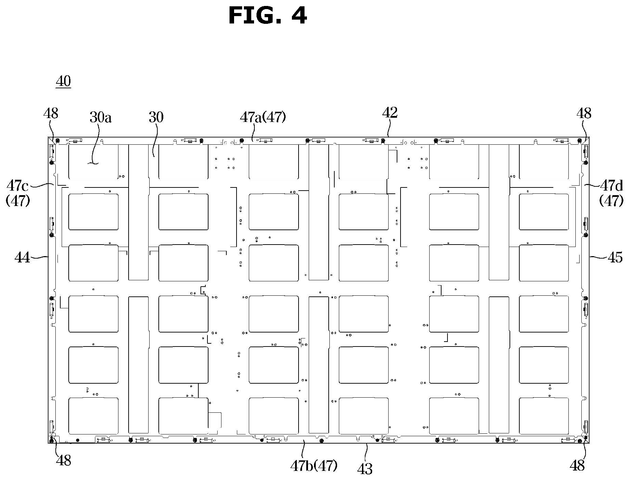

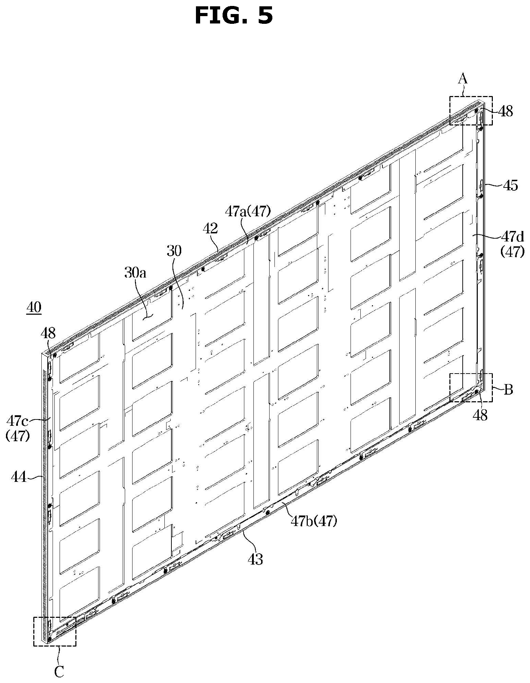

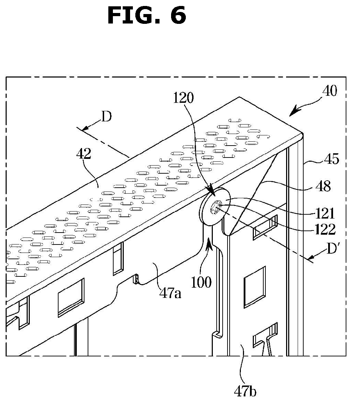

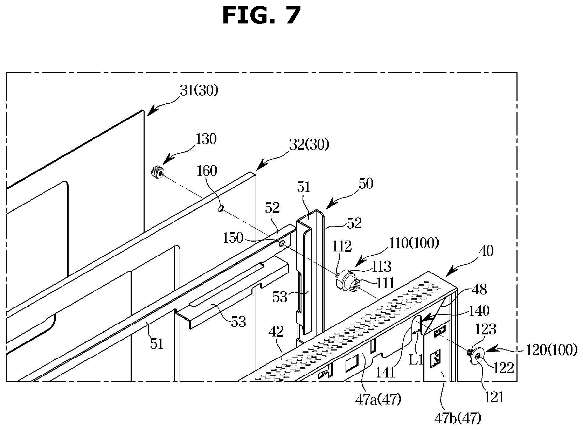

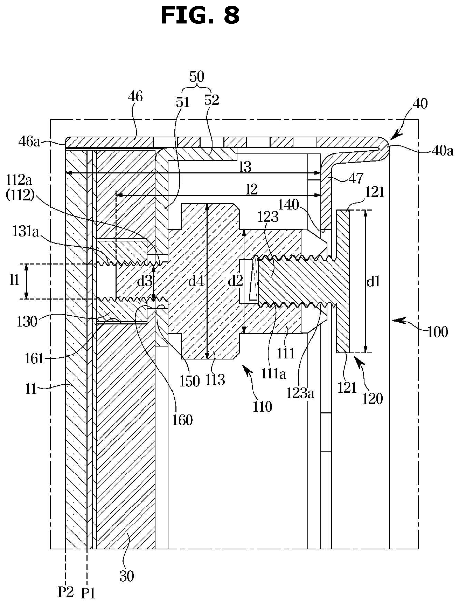

FIG. 4 is a rear view illustrating a partial configuration of the display apparatus of FIG. 1, FIG. 5 is a rear exploded perspective view of the display apparatus of FIG. 5, FIG. 6 is an enlarged view of a portion A of FIG. 5, FIG. 7 is an exploded perspective view of the portion A of FIG. 5, and FIG. 8 is a cross-sectional view of a D-D' portion of FIG. 5.

As illustrated in FIGS. 4 to 7, the display apparatus 1 may include the frame 30 provided in a shape corresponding to the display panel 11 at the rear side of the display panel 11.

The frame 30 is provided to support the display panel 11. When the display panel 11 includes a self-luminous inorganic light-emitting element 70, the display apparatus 1 may not require a separate backlight. In a non-self-luminous display apparatus including a backlight, the rear chassis provided to support the backlight may serve to support the display panel 11, but in a display apparatus 1 without a backlight, a separate configuration provided to support the display panel 11 may be required. When the frame 30 having a stiffness capable of supporting the display panel 11 is coupled to the rear side of the display panel 11, difficulties such as bending of the display panel 11 may be prevented.

The frame 30 may include a frame opening 30a that is open in the front and rear direction. The display module 10 and a driving circuit board (not shown) located at the rear side of the frame 30 may be connected through the frame opening 30a.

The display apparatus 1 may include the front chassis 40 extending along an edge of the display panel 11. The front chassis 40 may be provided to cover at least a portion of the edge of the display panel 11. The front chassis 40 may have a rectangular shape to correspond to the shape of the display panel 11.

The front chassis 40 may be formed through a roll forming process. The front chassis 40 may include a first portion 46 formed parallel to sides of the display panel 11, and a flange 47 extending from the first portion 46 and formed to face the rear cover 20 so as to be coupled to the rear cover 20. A curved portion 40a may be formed between the first portion 46 of the front chassis 40 and the flange 47 (refer to FIG. 8).

The first portion 46 of the front chassis 40 may be provided to cover the side surface of the display panel 11. At least a portion of the first portion 46 of the front chassis 40 may form a bezel 46a of the display apparatus 1.

The first portion 46 of the front chassis 40 and the flange 47 formed by extending from the first portion 46 may be formed by roll forming. When the front chassis 40 is roll formed, a portion, in which a material is locally compressed and stretched, may be formed, and thus the bending may occur. Due to the bending of the front chassis 40, the front chassis 40 may be retracted relative to the display panel 11, and thus a case, in which the side surface of the display panel 11 is not protected, may occur.

In addition, when the front chassis 40 protrudes more than the display panel 11 although the front chassis 40 is retracted, the bezel protrusion of the front chassis 40 may be excessive, which may interfere with the immersion of the screen and deteriorate the appearance quality.

In the present disclosure, a step adjusting device 100 for securing a constant protrusion amount at the edge of the display panel 11 by preventing the display panel 11 from being retracted due to the bending of the front chassis 40 and by adjusting the protrusion amount will be disclosed. The step adjusting device 100 will be described later.

The front chassis 40 may include an upper side portion 42 provided to cover an upper portion of the display panel 11, a lower side portion 43 provided to cover a lower portion of the display panel 11, a right side portion 45 provided to cover a right portion of the display panel 11, and a left side portion 44 provided to cover a left portion of the display panel.

The upper side portion 42 of the front chassis 40 may include a first portion 46 and an upper side portion flange 47a formed by extending from the first portion 46. The upper side portion 42 of the front chassis 40 may be provided to cover at least a portion of the upper portion of the display panel 11 and the display module 10.

The lower side portion 43 of the front chassis 40 may include a first portion 46 and a lower side portion flange 47b formed by extending from the first portion 46. The lower side portion 43 of the front chassis 40 may be provided to cover at least a portion of the lower portion of the display panel 11 and the display module 10.

The right side portion 45 of the front chassis 40 may include a first portion 46 and a right side portion flange 47d formed by extending from the first portion 46. The right side portion 45 of the front chassis 40 may be provided to cover at least a portion of the right side portion of the display panel 11 and the display module 10.

The left side portion 44 of the front chassis 40 may include a first portion 46 and a left side portion flange 47c formed by extending from the first portion 46. The left side portion 44 of the front chassis 40 may be provided to cover at least a portion of the left side portion of the display panel 11 and the display module 10.

The front chassis 40 may be provided such that the upper side portion 42 and the right side portion 45 are coupled, the right side portion 45 and the lower side portion 43 are coupled, the lower side portion 43 and the left side portion 44 are coupled, and the left side portion 44 and the upper side portion 42 are coupled so as to cover side edges of the display panel 11 and the display module 10.

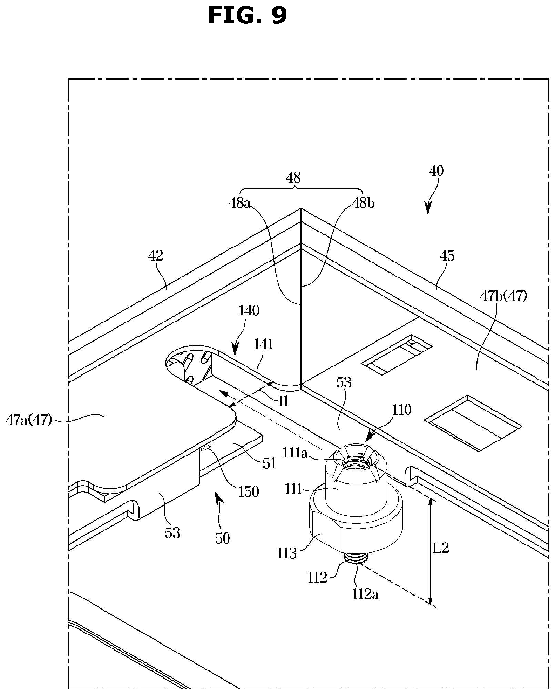

The upper side portion flange 47a and the right side portion flange 47d forming one of four corners of the front chassis 40 may be provided to be in contact with each other in a diagonal shape. The upper side portion flange 47a and the right side portion flange 47d may be formed in shapes corresponding to each other. Ends of the upper side portion flange 47a and the right side portion flange 47d may each include a diagonal portion 48 formed in a diagonal shape. One end of the upper side portion flange 47a may be formed as a first diagonal line 48a in a diagonal shape. One end of the right side portion flange 47d may be formed as a second diagonal line 48b in a diagonal shape. The first diagonal line 48a and the second diagonal line 48b may be arranged to face each other. The first diagonal line 48a and the second diagonal line 48b may be coupled to form a flat surface (refer to FIG. 9).

In the embodiment, it is illustrated that the upper side portion flange and the right side portion flange of the front chassis are formed in a diagonal shape and connected to each other, but is not limited thereto. For example, the shape of the diagonal portion may be changed in various ways. For example, the upper side portion flange and the right side portion flange may be formed in different lengths and connected to each other.

The step adjusting device 100 according to the embodiment may be configured to adjust a step among the front chassis 40, the display panel 11 and the display module 10. The step adjusting device 100 may be configured to adjust the step between the bezel 46a of the front chassis 40 and the screen.

The step adjusting device 100 may be provided on the four edges of the display apparatus 1. The step adjusting device 100 may be provided on at least a portion of the front chassis 40. In the embodiment, the step adjusting device 100 is provided on the upper side portion 42 of the front chassis 40 in ten pieces, but is not limited thereto. The number and installation locations of the step adjusting devices may vary depending on the size of the display apparatus.

Hereinafter the step adjusting device 100 positioned at an upper right corner (portion A of FIG. 5) of the display apparatus 1 will be described.

The step adjusting device 100 may be configured to adjust the step among the front chassis 40, the display panel 11, and the display module 10. The step adjusting device 100 may be configured to adjust a protrusion amount of the screen and the bezel 46a of the display apparatus 1.

The display apparatus 1 may further include a bracket 50 provided between the front chassis 40 and the rear cover 20. The bracket 50 may be provided to support the front chassis 40 between the front chassis 40 and the rear cover 20. The bracket 50 may be provided to support the front chassis 40. The bracket 50 may be provided between the frame 30 and the front chassis 40. The bracket 50 may be provided at the rear side of the frame 30. The bracket 50 may be provided to support the front chassis 40 at the rear side of the frame 30.

The bracket 50 may include a front support portion 51 and a side support portion 52. The front support portion 51 of the bracket 50 may be provided to support a portion of a rear surface of the frame 30. The bracket 50 may include a rear support portion 53 formed by extending from the front support portion 51. The rear support portion 53 may be formed by extending vertically rearward from the front support portion 51. The rear support portion 53 may be provided to support the flange 47 of the front chassis 40.

The bracket 50 may include a first bracket 50 provided to correspond to the upper side portion 42 and lower side portion 43 of the front chassis 40, and a second bracket 50 provided to correspond to the right side portion 45 and left side portion 44 of the front chassis 40.

The step adjusting device 100 may include a connecting member 110 and an adjusting member 120 coupled to the connecting member 110 to allow the front chassis 40 to move in the front and rear direction.

The step adjusting device 100 may include the connecting member 110 provided to connect the front chassis 40 and the bracket 50. The step adjusting device 100 may include the adjusting member 120 that penetrates the front chassis 40 and is coupled to the connecting member 110, and that allows the front chassis 40 to move in the front and rear direction according to an amount of fastening with the connecting member 110.

The adjusting member 120 may include a head portion 121 including one of a cross groove 122 or a straight groove (not shown) formed on an upper surface, and a cylindrical adjusting body portion 123 extending downward from the head portion 121. The head portion 121 may be formed in a disc shape. The head portion 121 may be a disc having a first diameter d1. The adjusting body portion 123 may be formed to extend downward from a center of the head portion 121. A screw thread 123a may be formed on an outer circumferential surface of the adjusting body portion 123.

The adjusting member 120 may be fastened to the connecting member 110 through an adjusting member coupling portion 140 formed in the front chassis 40. The adjusting member 120 may be coupled to the connecting member 110 by penetrating the adjusting member coupling portion 140. The adjusting member coupling portion 140 may be formed in the flange 47 of the front chassis 40. The adjusting member coupling portion 140 may be formed by penetrating at least a portion of the front chassis 40. The adjusting member coupling portion 140 may include a coupling slit 141 formed by penetrating at least a portion of the flange 47. The coupling slit 141 may be formed in the flange 47 of the front chassis 40. The coupling slit 141 may be formed upward from a lower side of the upper side portion flange 47a. The adjusting member coupling portion 140 may be formed with a first length 11. The coupling slit 141 may be formed with the first length 11. An entrance of the coupling slit 141 may be formed with the first length 11. The first length 11 of the adjusting member coupling portion 140 may be formed to be less than the first diameter d1 of the head portion 121. That is, the first diameter d1 of the head portion 121 may be formed to be greater than the first length 11 of the adjusting member coupling portion 140.

The adjusting member 120 may be coupled to the connecting member 110 by penetrating the adjusting member connecting portion 140 of the front chassis 40.

The connecting member 110 may be provided to connect the front chassis 40 and the bracket 50. The connecting member 110 may include a female screw portion 111 in which a female screw 111a is formed, and a male screw portion 112 in which a male screw 112a is formed. The connecting member 110 may be a double screw in which the male screw 112a and the female screw 111a are formed simultaneously. The female screw portion 111 and the male screw portion 112 may be positioned on opposite sides. The female screw portion 111 in which the female screw 111a is formed may be formed on one side of the connecting member 110, and the male screw portion 112 in which the male screw 112a is formed may be formed on the other side of the connecting member 110. A screw body 113 may be provided between the female screw portion 111 and the male screw portion 112 to support the bracket 50. The female screw portion 111 may be provided on one side and the male screw portion 112 may be provided on the other side with respect to the screw body 113.

The female screw portion 111 of the connecting member 110 is provided in a cylindrical shape and is provided with the female screw 111a formed therein. The male screw portion 112 of the connecting member 110 is provided in a cylindrical shape and is provided with the male screw 112a formed on the outer circumferential surface. The female screw portion 111 of the connecting member 110 may be formed with a second diameter d2. The second diameter d2 of the female screw portion 111 may be formed to be less than the first diameter d1 of the head portion 121. The male screw portion 112 may have a third diameter d3, and the screw body 113 may have a fourth diameter d4. The fourth diameter d4 of the screw body 113 may be formed to be greater than the second diameter d2 of the female screw portion 111. The third diameter d3 of the male screw portion 112 may be formed to be less than the second diameter d2 of the female screw portion 111.

The adjusting member 120 may be fastened to the female screw portion 111 of the connecting member 110. The female screw 111a formed in the female screw portion 111 of the connecting member 110 may be provided in a size and shape corresponding to the adjusting body portion 123 of the adjusting member 120. The screw thread 123a formed in the adjusting body portion 123 of the adjusting member 120 may be provided to correspond to the female screw 111a of the female screw portion 111 of the connecting member 110.

The connecting member 110 may be fastened to the bracket 50. The bracket 50 may be provided with a connecting member coupling portion 150 to which the connecting member 110 is coupled. The connecting member coupling portion 150 may be formed at a position corresponding to the adjusting member coupling portion 140. The male screw portion 112 of the connecting member 110 may be coupled to the connecting member coupling portion 150 of the bracket 50. The male screw portion 112 may penetrate the connecting member coupling portion 150 and be fixed by a fixing member 130. The fixing member 130 may be coupled to the male screw 112a of the male screw portion 112 that penetrates the connecting member coupling portion 150 of the bracket 50. A fixing member screw thread 131a corresponding to the male screw 112a may be formed on an inside of the fixing member 130.

The fixing member 130 may be provided in the frame 30. A connecting member through-hole 160 may be formed in the frame 30 to allow the connecting member 110 to be coupled thereto. The connecting member through-hole 160 may be formed at a position corresponding to the connecting member coupling portion 150. A fixing member receiving portion 161 may be formed in the frame 30 to allow the fixing member 130 coupled to the connecting member 110 through the connecting member through-hole 160 to be received therein. The fixing member receiving portion 161 may be formed to be connected to the connecting member through-hole 160. The frame 30 may include a module attachment layer 31 and a frame panel 32. The connecting member through-hole 160 may be formed in the module attachment layer 31 of the frame 30, and the fixing member receiving portion 161 may be formed in the frame panel 32.

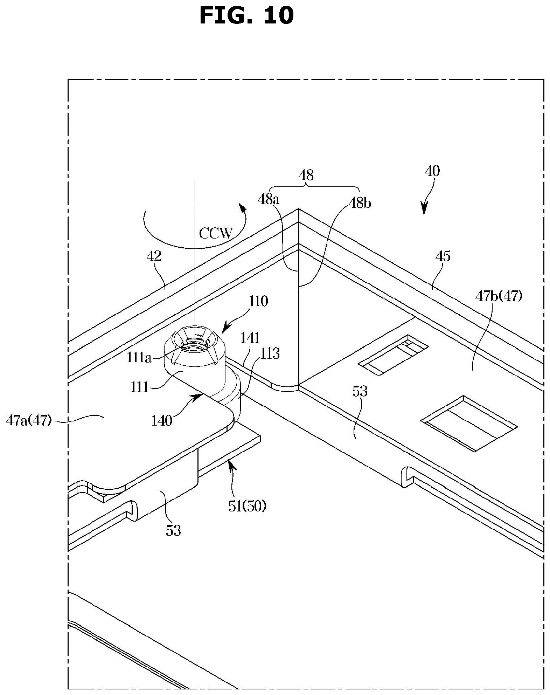

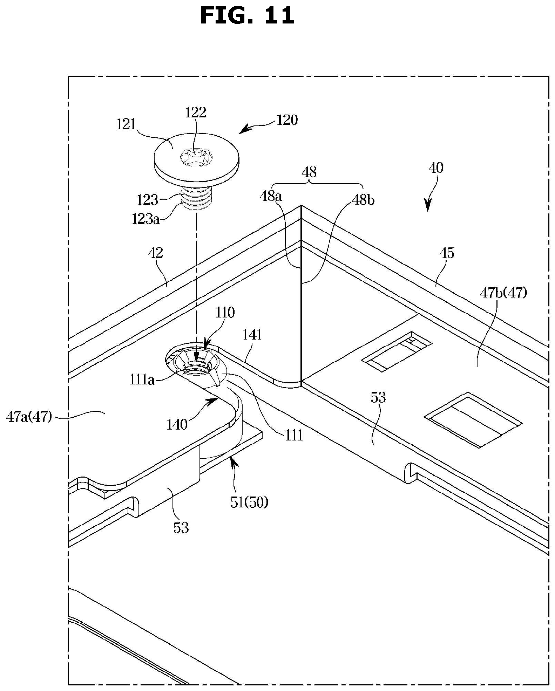

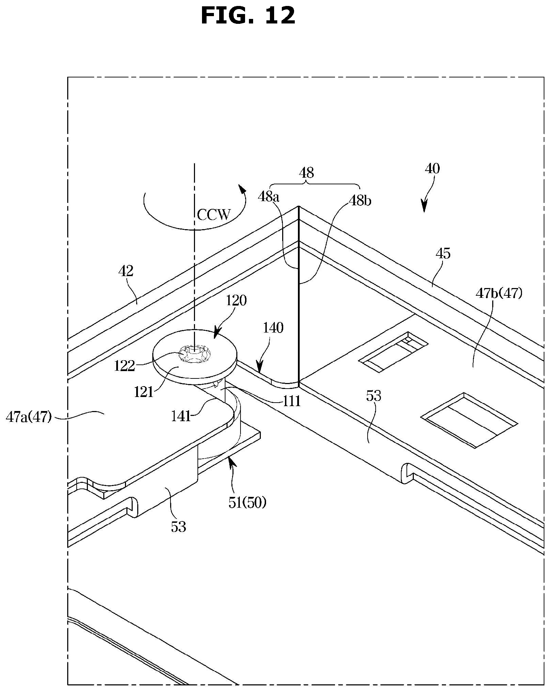

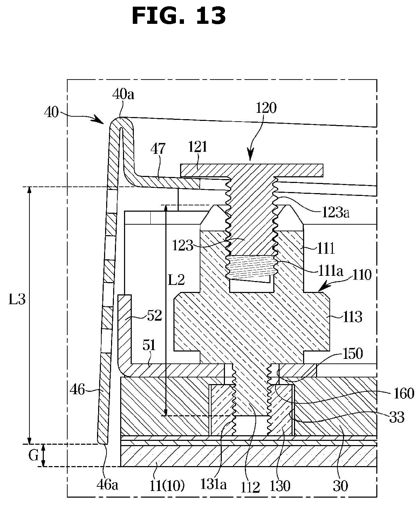

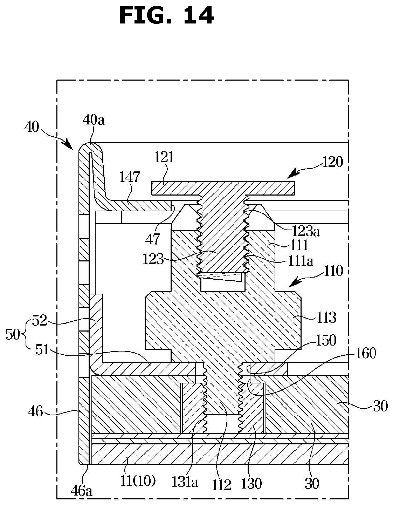

FIGS. 9 and 10 are views illustrating a method of fastening a connecting member according to one embodiment, FIGS. 11 and 12 are views illustrating fastening of an adjusting member fastened to the connecting member according to one embodiment, and FIGS. 13 and 14 are views illustrating an operating state of the adjusting member according to one embodiment. Hereinafter descriptions the same as the above descriptions will be omitted.

As illustrated in FIGS. 9 to 12, a method for assembling the step adjusting device 100 for adjusting the step among the display panel 11, the display module 10, and the bezel 46a of the display apparatus 1 will be described.

The connecting member 110 provided to connect the front chassis 40 and the bracket 50 is coupled to the adjusting member connecting portion 140 of the front chassis 40. The connecting member 110 is coupled to the adjusting member connecting portion 140 by allowing the male screw portion 112 to face the bracket 50 and by inserting the female screw portion 111 toward the connecting slit 141 of the adjusting member connecting portion 140.

When the screw body 113 and the female screw portion 111 of the connecting member 110 is coupled to the coupling slit 141 of the front chassis 40, the male screw portion 112 is coupled to the connecting member coupling portion 150 of the bracket 50. The connecting member 110 may be coupled by rotating the male screw portion 112 in a first direction (counter clock wise (CCW)) to the connecting member coupling portion 150. In the embodiment, it is illustrated that the male screw portion of the connecting member is rotated in the first direction, that is, counterclockwise, so as to be coupled to the connecting member coupling portion, but is not limited thereto. For example, a rotational direction for coupling the male screw of the male screw portion and the connecting member coupling portion may be changed.

When the male screw portion 112 of the connecting member 110 is coupled to the connecting member coupling portion 150, the screw body 113 of the connecting member 110 is supported by the bracket 50.

When the connecting member 110 is fixed to the bracket 50, the adjusting member 120 is fastened to the female screw portion 111 of the connecting member 110.

The adjusting body portion 123 of the adjusting member 120 is fastened to the female screw portion 111 of the connecting member 110. The screw thread 123a of the adjusting body portion 123 is rotated to be coupled to the female screw 111a. The adjusting member 120 may be coupled by being rotated in the first direction (CCW). In the embodiment, it is illustrated that the adjusting member is coupled by being rotated in the first direction, which is counterclockwise, but is not limited thereto. For example, the rotational direction for coupling the female screw of the female screw portion and the adjusting member may be changed.

The adjusting member 120 may be coupled to the female screw portion 111 of the connecting member 110 by rotating the cross groove 122 formed on the upper surface of the head portion 121 using a separate rotating member (not shown).

When the adjusting member 120 is coupled to the female screw portion 111 of the connecting member 110, the head portion 121 of the adjusting member 120 supports the flange 47 of the front chassis 40 so as to press the flange 47 from the rear to the front. The head portion 121 of the adjusting member 120 supports the front chassis 40 so as to press the front chassis forward, that is toward the screen.

The head portion 121 of the adjusting member 120 is rotated and coupled to the female screw portion 111 of the connecting member 110 to move forward, and the flange 47 of the front chassis 40 supported by the head portion 121 of the adjusting member 120 is pressed forward by the head portion 121 to move.

The bezel 46a formed in the end of the first portion 46 of the front chassis 40 forms a predetermined gap G from the display panel 11 and the display module 10. The gap G between the screen of the display apparatus 1 and the bezel 46a prevents the front chassis 40 from covering the side surfaces of the display panel 11 and the display module 10.

When the adjusting member 120 of the step adjusting device 100 is rotated to press and move the flange 47 of the front chassis 40 forward, the flange 47 of the front chassis 40 moves forward. Accordingly, the first portion 46 formed integrally with the front chassis 40 and the bezel 46a which is part of the first portion 46 also move forward. The bezel 46a of the front chassis 40 moves forward, that is toward the screen.

Conversely, when the bezel 46a of the front chassis 40 protrudes excessively beyond the screen, the head portion 121 of the adjusting member 120 is rotated in a second direction to allow the front chassis 40 to move rearward, thereby causing the bezel 46a to move rearward, that is in the opposite direction to the screen.

By rotating the head portion 121 of the adjusting member 120, the bezel 46a may be adjusted to protrude more than the display panel 11 and the display module 10 of the display apparatus 1. By rotating and adjusting the head portion 121 of the adjusting member 120, the front chassis 40 may be allowed to protrude forward to cover the side portion of the display module 10 and the display panel 11. By rotating the head portion 121 of the adjusting member 120, the front chassis 40 may be moved forward and/or backward, to adjust the protrusion amount of the bezel 46a to be a constant amount.

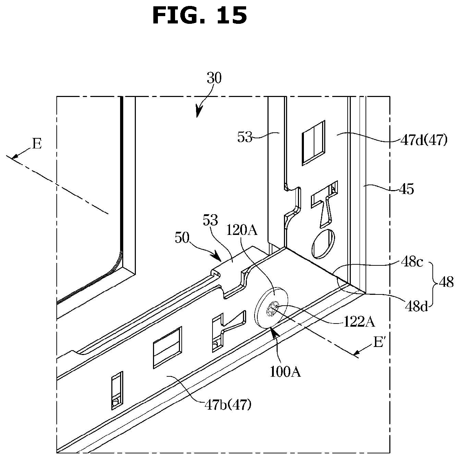

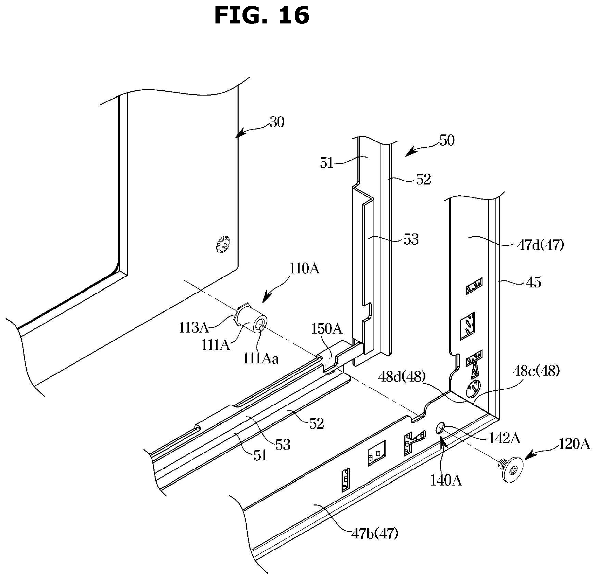

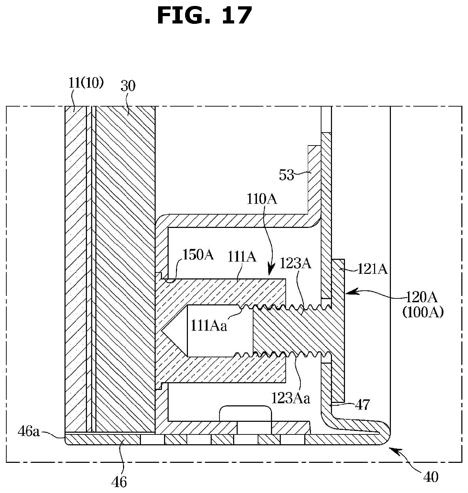

FIG. 15 is an enlarged view of a portion B of FIG. 5, FIG. 16 is an exploded perspective view of the portion B shown in FIG. 15, and FIG. 17 is a cross-sectional view of a E-E' portion of FIG. 15. Hereinafter descriptions the same as the above descriptions will be omitted.

As illustrated in FIGS. 15 to 17, a step adjusting device 100A may be configured to adjust a step between the bezel 46a of the front chassis 40 and the screen.

The step adjusting device 100A may be provided on four edges of the display apparatus 1. Hereinafter the step adjusting device 100A positioned at a lower right corner (portion B of FIG. 5) of the display apparatus 1 will be described.

The step adjusting device 100A may be configured to adjust a protrusion amount of the screen and the bezel 46a of the display apparatus 1.

The step adjusting device 100A may include a connecting member 110A and an adjusting member 120A coupled to the connecting member 110A so as to allow the front chassis 40 to move forward and backward.

The connecting member 110A may be provided to connect the front chassis 40 and the bracket 50. The adjusting member 120A may penetrate the front chassis 40 and be coupled to the connecting member 110A, and may allow the front chassis 40 to move forward and backward depending on an amount of fastening with the connecting member 110A.

The adjusting member 120A may include a head portion 121A including one of a cross groove 122A or a straight groove (not shown) formed on an upper surface, and a cylindrical adjusting body portion 123A extending downward from the head portion 121A. The adjusting body portion 123A may be formed by extending from a lower center of the head portion 121A. A screw thread 123Aa may be formed on an outer circumferential surface of the adjusting body portion 123A.

The front chassis 40 may be provided with an adjusting member connecting portion 140A through which the adjusting member 120A may penetrate and be fastened to the connecting member 110A. The adjusting member connecting portion 140A may be formed by penetrating at least a portion of the front chassis 40. The adjusting member connecting portion 140A may include a connecting hole 142A formed by penetrating at least a portion of the flange 47. The connecting hole 142A may be formed in the flange 47 of the front chassis 40.

The adjusting member 120A may be coupled to the connecting member 110A by penetrating the adjusting member connecting portion 140A of the front chassis 40.

The connecting member 110A may be provided to connect the front chassis 40 and the bracket 50. The connecting member 110A may include a cylindrical female screw portion 111A in which a female screw 111Aa is formed. A screw body 113A may be provided at one end of the female screw portion 111A to support the bracket 50.

The adjusting member 120A may be fastened to the female screw portion 111A of the connecting member 110A. The female screw 111Aa formed in the female screw portion 111A of the connecting member 110A may be provided in a size and shape corresponding to the adjusting body portion 123A of the adjusting member 120A.

The connecting member 110A may be fastened to the bracket 50. The bracket 50 may be provided with a connecting member coupling portion 150A to which the connecting member 110A is coupled. The connecting member coupling portion 150A may be formed at a position corresponding to the adjusting member coupling portion 140A. The screw body 113A of the connecting member 110A may be coupled to the connecting member coupling portion 150A of the bracket 50.

The adjusting member 120A may be connected to the female screw portion 111A of the connecting member 110A by rotating the cross groove 122A formed on the upper surface of the head portion 121A using a separate rotating member (not shown).

When the adjusting member 120A is coupled to the female screw portion 111A of the connecting member 110A, the head portion 121A of the adjusting member 120A presses the flange 47 of the front chassis 40 from the rear to the front. The head portion 121A of the adjusting member 120A supports the front chassis 40 to press the front chassis 40 forward, that is toward the screen.

By rotating the head portion 121A of the adjusting member 120A, the bezel 46a may be adjusted to protrude more than the display panel 11 and the display module 10 of the display apparatus 1. By rotating and adjusting the head portion 121A of the adjusting member 120A, the front chassis 40 may be allowed to protrude forward to cover the side portion of the display module 10 and the display panel 11. By rotating the adjusting member 120A, the front chassis 40 may be moved forward and/or backward, thereby adjusting a protrusion amount of the bezel 46a.

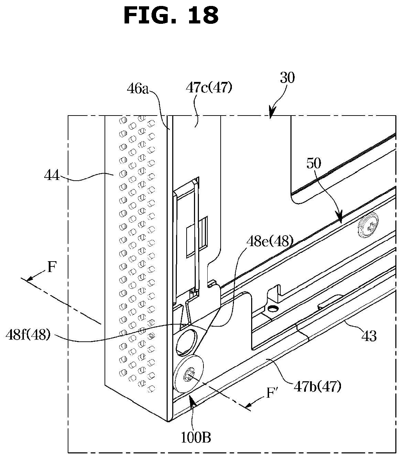

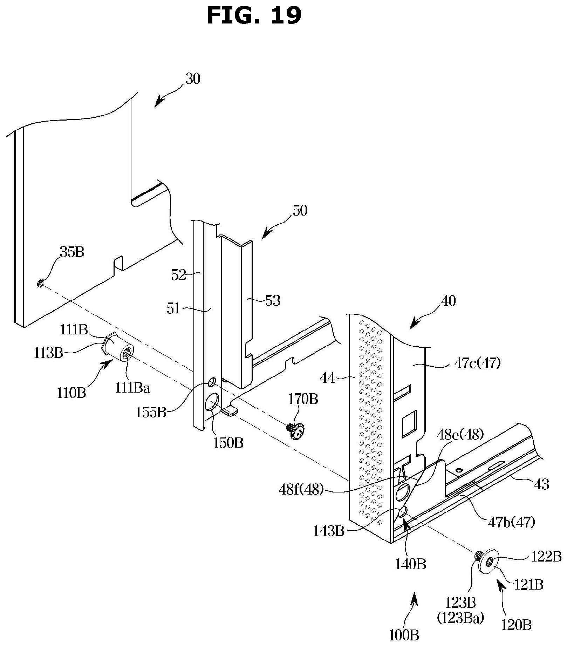

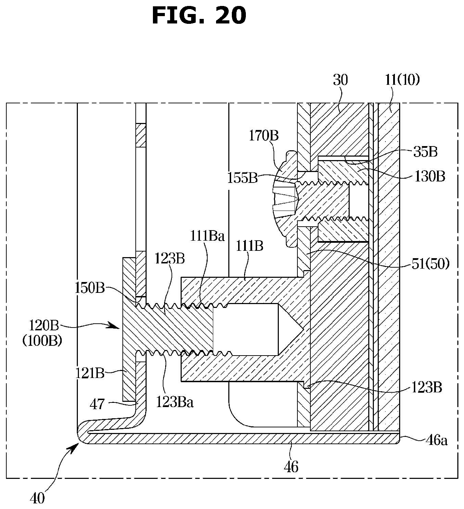

FIG. 18 is an enlarged view of a portion C of FIG. 5, FIG. 19 is an exploded perspective view of the portion C shown in FIG. 18, and FIG. 20 is a cross-sectional view of a F-F' portion of FIG. 18. Hereinafter descriptions the same as the above descriptions will be omitted.

A step adjusting device 100B may be mounted on the four edges of the display apparatus 1. Hereinafter the step adjusting device 100B positioned at a lower left corner (portion C of FIG. 5) of the display apparatus 1 will be described.

The step adjusting device 100B may include a connecting member 110B and an adjusting member 120B coupled to the connecting member 110B to allow the front chassis 40 to move forward and backward.

The connecting member 110B may be provided to connect the front chassis 40 and the bracket 50. The adjusting member 120B may penetrate the front chassis 40 and be coupled to the connecting member 110B, and may allow the front chassis 40 to move forward and backward depending on an amount of fastening with the connecting member 110B.

The adjusting member 120B may include a head portion 121B including one of a cross groove 122B or a straight groove (not shown) formed on an upper surface, and a cylindrical adjusting body portion 123B extending downward from the head portion 121B. A screw thread 123Ba may be formed on an outer circumferential surface of the adjusting body portion 123B.

The adjusting member 120B is fastened to the connecting member 110B by penetrating the adjusting member connecting portion 140B formed in the front chassis 40. The adjusting member connecting portion 140B may include a connecting hole 143B formed by penetrating at least a portion of the flange 47.

The connecting member 110B may be provided to connect the front chassis 40 and the bracket 50. The connecting member 110B may include a cylindrical female screw portion 111B in which a female screw 111Ba is formed. A screw body 113B may be provided at one end of the female screw portion 111B to support the bracket 50.

The adjusting member 120B may be fastened to the female screw portion 111B of the connecting member 110B. The connecting member 110B may be fastened to the bracket 50. The bracket 50 may be provided with a connecting member coupling portion 150B to which the connecting member 110B is coupled. The connecting member coupling portion 150B may be formed at a position corresponding to the adjusting member coupling portion 140B. The screw body 113B of the connecting member 110B may be fastened to the connecting member coupling portion 150B of the bracket 50.

The adjusting member 120B may be coupled to the female screw portion 111B of the connecting member 110B by rotating the cross groove 122B formed on the upper surface of the head portion 121B using a separate rotating member (not shown).

When the adjusting member 120B is coupled to the female screw portion 111B of the connecting member 110B, the head portion 121B of the adjusting member 120B presses the flange 47 of the front chassis 40 from the rear to the front. The head portion 121B of the adjusting member 120B supports the front chassis 40 to press the front chassis 40 forward, that is, toward the screen.

By rotating the adjusting member 120B, the bezel 46a may be adjusted to protrude more than the screen of the display apparatus 1. By rotating and adjusting the head portion 121B of the adjusting member 120B, the front chassis 40 may be allowed to protrude forward to cover the side portion of the display module 10 and the display panel 11.

The bracket 50 of the display apparatus 1 may be provided to support the display panel 11 at the rear of the display panel 11 and to support the front chassis 40 between the front chassis 40 and the frame 30.

The bracket 50 may be fixed to the frame 30 via a fastening member 170B. A fixing hole 155B may be formed in the bracket 50 to allow the fastening member 170B to be penetrated and fastened. The fixing hole 155B of the bracket 50 may be provided at a position adjacent to the connecting member coupling portion 150B formed in the bracket 50 to allow the connecting member 110B to be fixed. The fixing hole 155B may be located at an upper portion of the connecting member coupling portion 150B. A fixing member 130B may be provided to fasten the fastening member 170B to the bracket 50.

The fixing member 130B may be provided on a frame 30B. The fixing portion 35B coupled to the fastening member 170B may be provided on the frame 30B. The fixing member 130B may be received in a fastening portion 35B and coupled to the fastening member 170B. The bracket 50 may be firmly fixed to the frame 30B by the fastening member 170B.

A display apparatus 1 according to one embodiment may include a display panel 11, a rear cover 20 provided to cover a rear side of the display panel, a front chassis 40 provided to cover a side portion of the display panel and including a flange 47 facing the rear cover to be coupled to the rear cover and a first portion forming a bezel of the display panel, a bracket 50 provided to support the flange between the front chassis and the rear cover, and a step adjusting device 100 configured to adjust a step between the bezel and the display panel. The step adjusting device may include a connecting member 110 provided to connect the front chassis to the bracket, and an adjusting member 120 provided to penetrate the front chassis and be coupled to the connecting member, the adjusting member 120 provided to allow the bezel to be moved forward or backward by being interlocked with the front chassis according to an amount of fastening with the connecting member. According to the present disclosure, the improved display apparatus has a structure configured to adjust a protrusion amount of the bezel, thereby adjusting a step between the screen and the bezel. Further, it is possible to prevent the front chassis from being retracted relative to the display module due to bending. Further, by adjusting the protrusion amount of the bezel, it is possible to secure a constant protrusion amount around the screen edge.

The adjusting member 120 may include a head portion 121 including one of a cross groove 122 or a straight groove formed on an upper surface, and a cylindrical adjusting body portion 123 extending downward from the head portion and including a screw thread 123a formed on an outer circumferential surface thereof. The protrusion amount of the bezel may be adjusted through the adjusting member, thereby adjusting the step between the screen and the bezel.

The connecting member 110 may include a female screw portion 111 in which a female screw 111a is formed, a male screw portion 112 arranged on the other side of the female screw portion, and in which a male screw 112a is formed, and a screw body 113 provided to support the bracket between the female screw portion and the male screw portion. The female screw portion may be formed on one side of the screw body and the male screw portion may be formed on the other side of the screw body. A first diameter d1 of the head portion may be formed to be greater than a second diameter d2 of the female screw portion. The connecting member and the adjusting member may be a structure configured to adjust the protrusion amount of the bezel, and may adjust the step between the screen and the bezel, and may secure a constant protrusion amount at the screen edge by adjusting the protrusion amount of the bezel.

The front chassis may include an adjusting member coupling portion 140 provided to allow the connecting member and the adjusting member to be penetrated. The adjusting member coupling portion may be disposed on the flange. The adjusting member coupling portion may include at least one of a hole and a slit 141 formed by penetrating at least a portion of the front chassis. The first diameter d1 of the head portion may be formed to be greater than the first length l1 of the adjusting member connecting portion. The bracket 50 may include a connecting member coupling portion 150 formed to correspond to the adjusting member coupling portion to allow the connecting member to be coupled thereto. The bracket 50 may include a front support portion 51, and a side support portion 52. The connecting member coupling portion may be provided on the front support portion. A second length 12 of the connecting member may be formed to be less than a third length 13 between the bezel and the flange of the front chassis. This structure is configured to adjust the protrusion amount of the bezel, thereby adjusting the step between the screen and the bezel. By adjusting the protrusion amount of the bezel, a constant protrusion amount may be secured at the screen edge.

The display apparatus may further include a frame 30 coupled to the display panel at the rear side of the display panel so as to support the display panel. The frame may include a connecting member through-hole 160 formed to correspond to the connecting member coupling portion to allow the connecting member to be coupled thereto. The frame may include a fixing member receiving portion 161 formed by being connected to the connecting member through-hole to allow the fixing member to be received therein.

This structure may adjust the step between the screen and the bezel, and by adjusting the protrusion amount of the bezel, a constant protrusion amount may be secured around the screen edge.

A display apparatus 1 according to one embodiment may include a display panel 11 including a self-luminous element, a frame 30 coupled to the display panel at a rear side of the display panel to support the display panel, a rear cover 20 provided to cover the rear side of the display panel, a front chassis 40 including a first portion 46 forming a bezel 46a of the display panel to cover a side portion of the display panel, and a flange 47 formed to extend from the first portion to face the rear cover, a bracket 50 provided to support the flange between the front chassis and the rear cover, a connecting member 110 provided with a male screw 112 formed on one side and a female screw 111 formed on the other side, so as to connect the front chassis and the bracket, and an adjusting member 120 provided to penetrate the front chassis and be fastened to the connecting member, the adjusting member provided to allow the front chassis to be interlocked therewith and moved according to rotation of the adjusting member, provided to allow the first portion to be moved forward in response to the rotation of the adjusting member in a first direction, and provided to allow the first portion to be moved backward in response to the rotation of the adjusting member in a second direction opposite to the first direction. According to the present disclosure, the improved display apparatus has a structure configured to adjust a protrusion amount of the bezel, thereby adjusting a step between the screen and the bezel. Further, it is possible to prevent the front chassis from being retracted relative to the display module due to bending. Further, by adjusting the protrusion amount of the bezel, a constant protrusion amount may be secured around the screen edge.

The adjusting member 120 may include a head portion 121 including one of a cross groove 122 or a straight groove formed on an upper surface, and a cylindrical adjusting body portion 123 extending downward from the head portion and including a screw thread 123a formed on an outer circumferential surface thereof. A first diameter d1 of the head portion may be formed to be greater than a second diameter d2 of the female screw portion 111 in which the female screw is formed. The front chassis may include an adjusting member coupling portion 140 provided to allow the connecting member and the adjusting member to be penetrated. The adjusting member coupling portion may be disposed on the flange. The adjusting member coupling portion may include at least one of a hole 142A and a slit 141 formed by penetrating at least a portion of the front chassis. The first diameter d1 of the head portion may be formed to be greater than the first length l1 of the adjusting member connecting portion. This structure may adjust the step between the screen and the bezel, and by adjusting the protrusion amount of the bezel, a constant protrusion amount may be secured around the screen edge.

According to the present disclosure, it is possible to adjust the step between the screen and the bezel through a structure configured to adjust the protrusion amount of the bezel.

Further, the front chassis may be prevented from being retracted relative to the display module due to bending.

Further, it is possible to secure a constant protrusion amount on the screen edge by adjusting the protrusion amount of the bezel.

Further, it is possible to protect the side portion of the screen by allowing the edge bezel portion of the screen to be higher than the display module, and it is possible to have the uniform protrusion amount to improve the appearance quality.

Further, a material, in which the protrusion amount of the screen is defective, may be modified and used without being discarded.

Additional aspects of the disclosure will be set forth in part in the description which follows and, in part, will be obvious from the description, or may be learned by practice of the disclosure.

While the present disclosure has been particularly described with reference to exemplary embodiments, it should be understood by those of skilled in the art that various changes in form and details may be made without departing from the spirit and scope of the present disclosure.

## Claims

1. A display apparatus comprising:
a display panel;
a rear cover provided to cover a rear side of the display panel;
a front chassis provided to cover a side portion of the display panel and comprising a flange facing the rear cover to be coupled to the rear cover, and a first portion forming a bezel of the display panel;
a bracket provided to support the flange between the front chassis and the rear cover; and
a step adjusting device configured to adjust a step between the bezel and the display panel,
wherein the step adjusting device comprises:
a connecting member provided to connect the front chassis to the bracket; and
an adjusting member provided to penetrate the front chassis and be coupled to the connecting member, the adjusting member provided to allow the bezel to be moved forward or backward by being interlocked with the front chassis according to an amount of fastening with the connecting member.

2. The display apparatus of claim 1, wherein
the adjusting member comprises:
a head portion comprising one of a cross groove or a straight groove formed on an upper surface; and
a cylindrical adjusting body portion extending downward from the head portion and comprising a screw thread formed on an outer circumferential surface thereof.

3. The display apparatus of claim 2, wherein
the connecting member comprises:
a female screw portion in which a female screw is formed;
a male screw portion arranged on the other side of the female screw portion, the male screw portion in which a male screw is formed; and
a screw body provided to support the bracket between the female screw portion and the male screw portion.

4. The display apparatus of claim 3, wherein
the female screw portion is formed on one side of the screw body and the male screw portion is formed on the other side of the screw body.

5. The display apparatus of claim 3, wherein
a first diameter of the head portion is formed to be greater than a second diameter of the female screw portion.

6. The display apparatus of claim 1, wherein
the front chassis comprises: an adjusting member coupling portion provided to allow the connecting member and the adjusting member to be penetrated,
wherein the adjusting member coupling portion is disposed on the flange.

7. The display apparatus of claim 6, wherein
the adjusting member coupling portion comprises: at least one of a hole and a slit formed by penetrating at least a portion of the front chassis.

8. The display apparatus of claim 5, wherein
the first diameter of the head portion is formed to be greater than a first length of the adjusting member connecting portion.

9. The display apparatus of claim 6, wherein
the bracket comprises: a connecting member coupling portion formed to correspond to the adjusting member coupling portion to allow the connecting member to be coupled thereto.

10. The display apparatus of claim 9, wherein
the bracket comprises: a front support portion provided to support one surface of the frame; and a side support portion provided to support one side,
wherein the connecting member coupling portion is provided on the front support portion.

11. The display apparatus of claim 5, wherein
a second length of the connecting member is formed to be less than a third length between the bezel and the flange of the front chassis.

12. The display apparatus of claim 3, further comprising:
a fixing member provided to be coupled to the male screw portion to fix the connecting member.

13. The display apparatus of claim 9, further comprising:
a frame coupled to the display panel at the rear side of the display panel so as to support the display panel,
wherein the frame comprises: a connecting member through-hole formed to correspond to the connecting member coupling portion to allow the connecting member to be coupled thereto.

14. The display apparatus of claim 13, wherein
the frame comprises a fixing member receiving portion formed by being connected to the connecting member through-hole to allow the fixing member to be received therein.
